# EUROPEAN PATENT SPECIFICATION

(11) **EP 4 145 516 B1**
(45) Date of publication and mention of the grant of the patent: **25.11.2026**
(21) Application number: 20897652.2
(22) Date of filing: 29.04.2020
(51) Int. Cl.: H10K 59/173, H10K 59/65

(54) **ORGANIC LIGHT-EMITTING DISPLAY SUBSTRATE AND MANUFACTURING METHOD THEREFOR, AND ORGANIC LIGHT-EMITTING DISPLAY DEVICE**
ORGANISCHES LICHTEMITTIERENDES ANZEIGESUBSTRAT UND HERSTELLUNGSVERFAHREN DAFÜR SOWIE EINE ORGANISCHE LICHTEMITTIERENDE ANZEIGEVORRICHTUNG
SUBSTRAT D'AFFICHAGE ÉLECTROLUMINESCENT ORGANIQUE ET SON PROCÉDÉ DE FABRICATION, ET DISPOSITIF D'AFFICHAGE ÉLECTROLUMINESCENT ORGANIQUE

(43) Date of publication of application: 08.03.2023
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: JIA, Li, Beijing 100176 (CN); GAO, Tao, Beijing 100176 (CN)
(74) Representative: Santarelli
(86) International application number: PCT/CN2020/087912
(87) International publication number: WO 2021/217526

(56) References cited:
- CN-A- 104 538 423
- CN-A- 107 732 019
- CN-A- 108 269 835
- CN-A- 108 717 942
- CN-A- 109 801 950
- CN-A- 110 047 886
- CN-A- 110 060 578
- CN-A- 110 634 928
- CN-A- 111 048 551
- KR-A- 20070 003 133
- US-A1- 2019 006 436
- US-B1- 6 280 273

## Description

### TECHNICAL FIELD

The present disclosure relates to the field of display technology, and in particularly to an organic light-emitting display substrate and a manufacturing method thereof, and an organic light-emitting display device.

### BACKGROUND

Due to a series of excellent characteristics such as self-luminescence, high contrast, wide viewing angle, low power consumption, fast response speed, and low manufacturing cost, the organic light-emitting device as a basis of a new-generation display device, has received more and more attention.

The production yield of the organic light-emitting display substrate is a problem that restricts large-scale application of the organic light-emitting display device.

US6280273B1 provides an organic EL display device comprising a plurality of organic EL elements each having at least a first electrode, one or more organic layers participating in light emission capability, and a second electrode, the elements being able to be independently electrically operated to emit light, and a groove structure at the boundary between adjacent organic EL elements for isolating at least one of the electrodes between the adjacent organic EL elements.

### SUMMARY

According to one aspect of the embodiments of the present disclosure, provided is an organic light-emitting display substrate according to claim 1.

In some embodiments, the organic functional layer comprises a plurality of first portions located at the passive matrix organic light-emitting display area and a plurality of second portions located at the passive matrix organic light-emitting display area, wherein each of the plurality of first portions is further away from the substrate than the anode layer, and each of the plurality of second portions is located within a partition groove of the plurality of partition grooves and is not connected to a first portion of the plurality of first portions adjacent to the each of the plurality of second portions.

In some embodiments, each of the plurality of shielding portions comprises two shielding strips located on both sides of the groove and spaced apart from each other, and an orthographic projection of each of the two shielding strips on the substrate partially overlaps with the orthographic projection of the groove on the substrate.

In some embodiments, the organic light-emitting display substrate further comprises a first data metal layer, a first inorganic layer, a second data metal layer, a pixel defining layer and a spacer layer on the one side of the substrate, wherein: the organic layer comprises a first organic layer and a second organic layer; the first data metal layer, the first inorganic layer, the first organic layer, the second data metal layer, the second organic layer, the anode layer, the pixel defining layer, the spacer layer, the organic functional layer and the cathode layer are arranged sequentially along a direction away from the substrate; and in the passive matrix organic light-emitting display area, the second data metal layer is connected to the first data metal layer through a plurality of first via holes and connected to the anode layer through a plurality of second via holes, and any two of the plurality of first anodes adjacent to each other along the first direction are connected to each other through the first data metal layer or the second data metal layer.

In some embodiments, each of the plurality of grooves penetrates through the second organic layer and extends into the first organic layer.

In some embodiments, an orthographic projection of each of the plurality of grooves on the substrate has a width of 5 microns to 10 microns along the first direction.

In some embodiments, each of the plurality of grooves on the substrate has a depth of 2 micrometers to 2.5 micrometers along a direction perpendicular to the substrate.

In some embodiments, an angle between each of two side walls and a bottom wall of each of the plurality of grooves is 120 degrees to 140 degrees.

In some embodiments, a portion of the orthographic projection of each of the two shielding strips on the substrate overlapping with the orthographic projection of the groove on the substrate has a width of 0.8 micron to 1 micron along the first direction.

In some embodiments, the organic light-emitting display substrate further comprises an active matrix organic light-emitting display area, the organic light-emitting display substrate further comprising a semiconductor layer, a first insulating layer, a first gate metal layer, a second insulating layer, a second gate metal layer and a third insulating layer which are located between the substrate and the first data metal layer and arranged sequentially along the direction away from the substrate, wherein: in the active matrix organic light-emitting display area, the first data metal layer is connected to the semiconductor layer through a plurality of third via holes and connected to the second data metal layer through a plurality of fourth via holes, and the anode layer is connected to the second data metal layer through a plurality of fifth via holes.

In some embodiments, the active matrix organic light-emitting display area surrounds a portion of an edge of the passive matrix organic light-emitting display area; or the active matrix organic light-emitting display area surrounds the edge of the passive matrix organic light-emitting display area.

In some embodiments, the substrate comprises a first organic flexible layer, a second organic flexible layer, and a first inorganic barrier layer located between the first organic flexible layer and the second organic flexible layer.

According to another aspect of the embodiments of the present disclosure, provided is an organic light-emitting display device comprising the organic light-emitting display substrate according to any one of the above embodiments.

In some embodiments, the organic light-emitting display substrate further comprises an active matrix organic light-emitting display area; and the organic light-emitting display device further comprises at least one functional device, an orthographic projection of which on the organic light-emitting display substrate is located at the passive matrix organic light-emitting display area.

According to still another aspect of the embodiments of the present disclosure, provided is a manufacturing method of an organic light-emitting display substrate as defined in claim 13.

In some embodiments, etching the organic layer comprises: forming a hard mask on the one side of the spacer layer away from the substrate, wherein areas of the hard mask corresponding to notches of the plurality of partition grooves are hollow areas; dry etching the organic layer through the hard mask to form the plurality of partition grooves; and peeling off the hard mask.

In some embodiments, forming the hard mask comprises: forming a hard mask cover layer and a photoresist cover layer sequentially on the one side of the spacer layer away from the substrate; exposing and developing the photoresist cover layer sequentially to obtain a photoresist protection mask, wherein areas of the photoresist protection mask corresponding to the notches of the plurality of partition grooves are hollow areas; and wet etching the hard mask cover layer through the photoresist protective mask to obtain the hard mask.

In some embodiments, a material of the hard mask comprises metal oxide.

In some embodiments, a material of the hard mask comprises indium gallium zinc oxide.

In some embodiments, forming the organic layer comprises forming a first organic layer and a second organic layer sequentially on the one side of the substrate, and the manufacturing method further comprises: forming a first data metal layer and a first inorganic layer sequentially on the one side of the substrate before forming the first organic layer; and forming a second data metal layer on one side of the first organic layer away from the substrate after forming the first organic layer and before forming the second organic layer, wherein in the passive matrix organic light-emitting display area, the second data metal layer is connected to the first data metal layer through a plurality of first via holes and connected to the anode layer through a plurality of second via holes, and any two of the plurality of first anodes adjacent to each other along the first direction are connected to each other through the first data metal layer or the second data metal layer.

In some embodiments, each of the plurality of grooves penetrates through the second organic layer and extends into the first organic layer.

In some embodiments, the organic light-emitting display substrate further comprises an active matrix organic light-emitting display area, and the manufacturing method further comprises: forming a semiconductor layer, a first insulating layer, a first gate metal layer, a second insulating layer, a second gate metal layer, and a third insulating layer sequentially on the one side of the substrate before forming the first data metal layer, wherein in the active matrix organic light-emitting display area, the first data metal layer is connected to the semiconductor layer through a plurality of third via holes and connected to the second data metal layer through a plurality of fourth via holes, and the anode layer is connected to the second data metal layer through a plurality of fifth via holes.

### BRIEF DESCRIPTION OF THE DRAWINGS

The accompanying drawings, which constitute part of this specification, illustrate exemplary embodiments of the present disclosure and, together with this specification, serve to explain the principles of the present disclosure.

The present disclosure may be more clearly understood from the following detailed description with reference to the accompanying drawings, in which:
Fig. 1a is a front view showing an organic light-emitting display substrate according to an embodiment of the present disclosure;
Fig. 1b is an enlarged schematic view showing an organic light-emitting display substrate at A in Fig. 1a according to an embodiment of the present disclosure;
Fig. 1c is a schematic cross-sectional view showing an organic light-emitting display substrate at B-B in Fig. 1b according to an embodiment of the present disclosure;
Fig. 1d is an enlarged schematic cross-sectional view showing a partition groove according to an embodiment of the present disclosure;
Fig. 2 is a front view showing an organic light-emitting display substrate according to another embodiment of the present disclosure;
Fig. 3a is a schematic cross-sectional view showing a passive matrix organic light-emitting display area of an organic light-emitting display substrate in the related art;
Fig. 3b shows some schematic cross-sectional views of a manufacturing process of an organic light-emitting display substrate in the related art;
Fig. 4a is a flow chart showing a manufacturing method of an organic light-emitting display substrate according to an embodiment of the present disclosure;
Fig. 4b shows some schematic cross-sectional views of a manufacturing process of an organic light-emitting display substrate according to an embodiment of the present disclosure;
Fig. 5a is a flow chart showing a manufacturing method of a partition groove according to an embodiment of the present disclosure;
Fig. 5b shows some schematic cross-sectional views of a manufacturing process of an organic light-emitting display substrate according to an embodiment of the present disclosure; and
Fig. 6 is a front view showing an organic light-emitting display device according to an embodiment of the present disclosure.

It should be understood that the dimensions of the various parts shown in the accompanying drawings are not necessarily drawn according to the actual scale. In addition, the same or similar reference signs are used to denote the same or similar components.

### DETAILED DESCRIPTION

Various exemplary embodiments of the present disclosure will now be described in detail with reference to the accompanying drawings. The following description of the exemplary embodiments is merely illustrative and is in no way intended as a limitation to the present disclosure, its application or use. The present disclosure may be implemented in many different forms, which are not limited to the embodiments described herein. These embodiments are provided to make the present disclosure thorough and complete, and fully convey the scope of the present disclosure to those skilled in the art. It should be noticed that: relative arrangement of components and steps, material composition, numerical expressions, and numerical values set forth in these embodiments, unless specifically stated otherwise, should be explained as merely illustrative, and not as a limitation.

The use of the terms "first", "second" and similar words in the present disclosure do not denote any order, quantity or importance, but are merely used to distinguish between different parts. A word such as "comprise", "have" or variants thereof means that the element before the word covers the element(s) listed after the word without excluding the possibility of also covering other elements. The terms "up", "down", or the like are used only to represent a relative positional relationship, and the relative positional relationship may be changed correspondingly if the absolute position of the described object changes.

In the present disclosure, when it is described that a specific component is disposed between a first component and a second component, there may be an intervening component between the specific component and the first component or between the specific component and the second component. When it is described that a specific part is connected to other parts, the specific part may be directly connected to the other parts without an intervening part, or not directly connected to the other parts with an intervening part.

Unless otherwise defined, all terms (including technical and scientific terms) used herein have the same meanings as the meanings commonly understood by one of ordinary skill in the art to which the present disclosure belongs. It should also be understood that terms as defined in general dictionaries, unless explicitly defined herein, should be interpreted as having meanings that are consistent with their meanings in the context of the relevant art, and not to be interpreted in an idealized or extremely formalized sense.

Techniques, methods, and apparatus known to those of ordinary skill in the relevant art may not be discussed in detail, but where appropriate, these techniques, methods, and apparatuses should be considered as part of this specification.

With the characteristics of small weight, small thicknesses and flexibility, the organic light-emitting display substrate is widely applied in a flexible display device. In order to improve the production yield of the organic light-emitting display substrate, the embodiments of the present disclosure provide an organic light-emitting display substrate and a manufacturing method thereof, and an organic light-emitting display device.

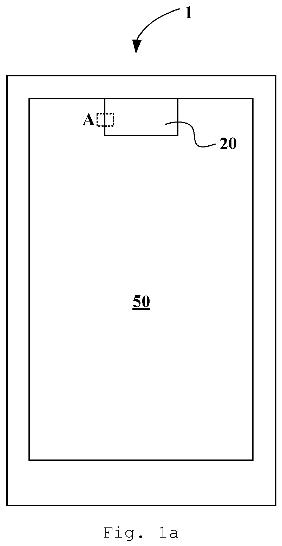

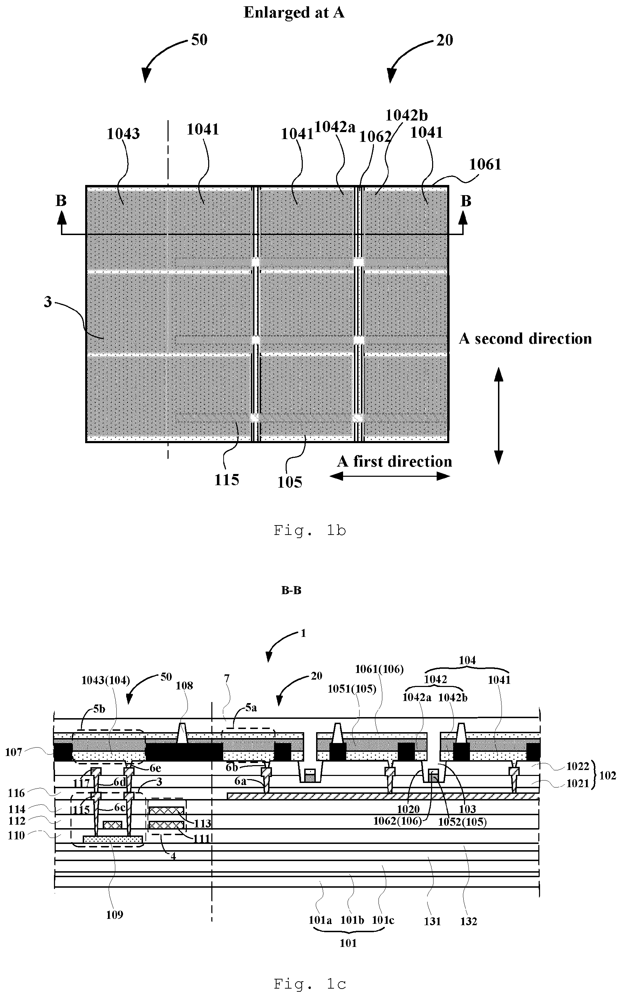

As shown in Fig. 1a, the organic light-emitting display substrate 1 provided by an embodiment of the present disclosure comprises a passive matrix organic light-emitting display area 20. Fig. 1b is an enlarged schematic view showing an organic light-emitting display substrate at A in Fig. 1a according to an embodiment of the present disclosure. The structure of a light shielding matrix is not shown by omission in Fig. 1b. Fig. 1c is a schematic cross-sectional view showing an organic light-emitting display substrate at B-B in Fig. 1b according to an embodiment of the present disclosure.

As shown in Figs. 1b and 1c, the organic light-emitting display substrate 1 provided by the embodiments of the present disclosure comprises a substrate 101, an organic layer 102, an anode layer 104, an organic functional layer 105, and a cathode layer 106.

The organic layer 102 is located on one side of the substrate 101 and comprising a plurality of grooves 1020 located at the passive matrix organic light-emitting display area 20. The plurality of grooves 1020 are spaced apart along a first direction and extend along a second direction.

The anode layer 104 is located on a surface of the organic layer 102 away from the substrate 101. The anode layer 104 comprises a plurality of first anodes 1041 located at the passive matrix organic light-emitting display area 20 and arranged in an array. The anode layer 104 further comprises a plurality of shielding portions 1042 located at the passive matrix organic light-emitting display area 20, spaced apart along the first direction and extending along the second direction. The orthographic projections of the plurality of shielding portions 1042 on the substrate 101 and the orthographic projections of the plurality of grooves 1020 on the substrate 101 are distributed in gaps of orthographic projections of a plurality of first anodes 1041 on the substrate 101. The gaps extend along the second direction. The orthographic projection of each shielding portion 1042 on the substrate 101 partially overlaps with the orthographic projection of a groove 1020 on the substrate 101 to form a partition groove 103.

The organic functional layer 105 is formed on one side of the anode layer 104 away from the substrate 101.

The cathode layer 106 is formed on one side of the organic functional layer 105 away from the substrate 101. The cathode layer 106 comprises a plurality of cathode strips 1061 located at the passive matrix organic light-emitting display area 20 and a plurality of cathode material portions 1062 located at the passive matrix organic light-emitting display area 20. The plurality of cathode strips 1061 and the plurality of cathode material portions 1062 extend along the second direction and are alternately arranged along the first direction. Each cathode strip 1061 is further away from the substrate 101 than the anode layer 104. Each cathode material portion 1062 is located within a partition groove 103 and is not connected to a cathode strip 1061 which is adjacent to this cathode material portion 1062.

In the embodiments of the present disclosure, the organic functional layer 105 is formed on one side of the anode layer 104 away from the substrate 101. It should be understood that the entire pattern layer of the organic functional layer 105 which is located on one side of entire pattern layer of the anode layer 104 away from the substrate 101, should not be understood as an absolute positional relationship of a partial structure. The positional relationships between other pattern layers which are similar to this will not be described in detail here.

As shown in Fig. 1c, in some embodiments of the present disclosure, the organic functional layer 105 comprises a plurality of first portions 1051 located at the passive matrix organic light-emitting display area 20 and a plurality of second portions 1052 located at the passive matrix organic light-emitting display area 20. Each first portion 1051 is further away from the substrate 101 than the anode layer 104. Each second portion 1052 is located within a partition groove 103 and is not connected to a first portion 1051 which is adjacent to this second portion 1052.

In the embodiments of the present disclosure, the first direction and the second direction are not specifically limited. For example, in some embodiments, the first direction is a row direction, and the second direction is a column direction. In other embodiments, the first direction is a column direction, and the second direction is a row direction.

The passive matrix organic light-emitting display area 20 of the organic light-emitting display substrate 1 comprises a plurality of passive matrix organic light-emitting diodes (PMOLED) arranged in an array, which are illuminated in a scanned manner. Each organic light-emitting device 5a emits light instantly under a short pulse. In the embodiment shown in Fig. 1a, the organic light-emitting display substrate 1 further comprises an active matrix organic light-emitting display area 50. As shown in Fig. 1c, the active matrix organic light-emitting display area 50 comprises a plurality of active-matrix organic light-emitting diodes 5b (AMOLED) arranged in an array. Each organic light-emitting device 5b is controlled by a thin film transistor device 3 and emit light independently and continuously.

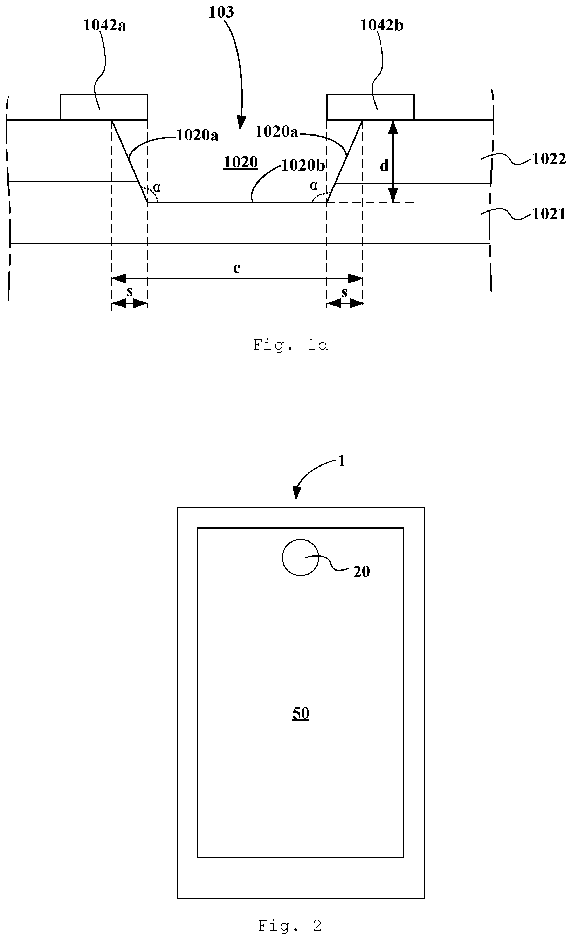

The shape of the passive matrix organic light-emitting display area 20 is not limited, for example, is circular, oval, rectangular or polygonal, and the like. The passive matrix organic light-emitting display area 20 is not required to be provided with a thin film transistor device, and thus has a relatively high transmittance. In the organic light-emitting display device, a functional device such as a camera or a distance sensor may be disposed on a back side of the organic light-emitting display substrate 1 and opposite to the passive matrix organic light-emitting display area 20, so that light can pass through the passive matrix organic light-emitting display area 20 to be incident on the functional device. Such a design is favorable for increasing a screen-to-body ratio of the organic light-emitting display device, and more suitable for a narrow frame and an ultra-narrow frame. In the embodiment shown in Fig. 1 a, the active matrix organic light-emitting display area 50 is arranged surrounding a portion of the edge of the passive matrix organic light-emitting display area 20. In the embodiment shown in Fig. 2, the active matrix organic light-emitting display area 50 may also surround the entire edge of the passive matrix organic light-emitting display area 20.

In some embodiments of the present disclosure, the organic light-emitting display substrate may also be a passive matrix organic light-emitting display substrate, and the display area of the organic light-emitting display substrate only comprises the passive matrix organic light-emitting display area.

As shown in Fig. 1c, in some embodiments, the organic layer 102 comprises a first organic layer 1021 and a second organic layer 1022 serving as planarization layers. The groove 1020 penetrates through the second organic layer 1022 and extends into the first organic layer 1021. The structure of the organic light-emitting display substrate 1 further comprises a second inorganic barrier layer 131, a buffer layer 132, a semiconductor layer 109, a first insulating layer 110, a first gate metal layer 111, a second insulating layer 112, a second gate metal layer 113, a third insulating layer 114, a first data metal layer 115, a first inorganic layer 116, a second data metal layer 117, a pixel defining layer 107 and a spacer layer 108 located on one side of the substrate 101 and arranged sequentially along a direction away from the substrate 101. The first organic layer 1021 is located between the first inorganic layer 116 and the second data metal layer 117, and the second organic layer 1022 is located between the second data metal layer 117 and the anode layer 104. The organic functional layer 105 is located on one side of the spacer layer 108 away from the substrate 101. In the passive matrix organic light-emitting display area 20, the second data metal layer 117 is connected to the first data metal layer 115 through a plurality of first via holes 6a, and connected to the anode layer 104 through a plurality of second via holes 6b.

In the passive matrix organic light-emitting display area 20, any two first anodes 1041 adjacent to each other along the first direction are connected to each other through the first data metal layer 115. That is, the plurality of first anodes 1041 arranged along the first direction are electrically conductive through the first data metal layer 115, so that the organic light-emitting devices 5a arranged in a matrix can be illuminated in a scanned manner. In other embodiments of the present disclosure, any two first anodes 1041 adjacent to each other along the first direction may also be connected to each other through the second data metal layer 117.

In the active matrix organic light-emitting display area 50, the first data metal layer 115 is connected to the semiconductor layer 109 through a plurality of third via holes 6c, and connected to the second data metal layer 117 through a plurality of fourth via holes 6d. In addition, in order to implement encapsulated protection of the internal structure of the organic light-emitting display substrate 1, the organic light-emitting display substrate 1 further comprises a thin film encapsulation layer 7.

The semiconductor layer 109 comprises an active layer of the thin film transistor device 3, the first gate metal layer 111 comprises a gate of the thin film transistor device 3 and a first plate of the capacitor device 4, the second gate metal layer 113 comprises a second plate of the capacitor device 4, the first data metal layer 115 comprises a first layer of a trace as well as a source and drain of the thin film transistor device 3, and the second data metal layer 117 comprises a second layer of the trace. The double-layer trace design is equivalent to connection of resistors in parallel and may reduce the resistance of the trace and further reduce the power consumption of the organic light-emitting display substrate 1.

In the active matrix organic light-emitting display area 50, the anode layer 104 comprises a plurality of second anodes 1043 arranged in an array. The plurality of second anodes 1043 are connected to the second data metal layer 117 through a plurality of fifth via holes 6e. In the passive matrix organic light-emitting display area 20, the first anode 1041, a portion of the organic functional layer 105 directly opposite to the first anode 1041, and a portion of the cathode strip 1061 directly opposite to the first anode 1041 constitute an organic light-emitting device 5a. In the active matrix organic light-emitting display area 50, the second anode 1043, a portion of the organic functional layer 105 directly opposite to the second anode 1043, and a portion of the cathode layer 106 directly opposite to the second anode 1043 constitute an organic light-emitting device 5b.

In some embodiments, the organic functional layer 105 and the cathode layer 106 of the organic light-emitting display substrate 1 are formed using an evaporation process. During the evaporation process, the evaporation material gas forms a film layer substantially along a normal direction of the substrate 101. Therefore, the undercut structure of the partition groove 103 may obstruct the evaporation material gas from forming a film on a sidewall of the groove 1020, so that a portion of the film layer located within the partition groove 103 is not connected to a portion of the film layer located outside the partition groove 103. That is, the film layer cannot be continuous on both sides of the partition groove 103. In the embodiments of the present disclosure, in the passive matrix organic light-emitting display area 20, due to the partition effect of the partition groove 103, the plurality of cathode strips 1061 of the cathode layer 106 extend along the second direction and are spaced apart along the first direction. In the active matrix organic light-emitting display area 50, the cathode layer 106 may extend continuously. The organic functional layer 105 may be formed by evaporation over a large area or formed by patterned evaporation using a mask.

In some embodiments of the present disclosure, as shown in Figs. 1b and 1c, the shielding portion 1042 comprises two shielding strips 1042a and 1042b located on both sides of the groove 1020 and spaced apart. The orthographic projection of each of the two shielding strips 1042a and 1042b on the substrate 101 partially overlaps with the orthographic projection of the groove 1020 on the substrate 101. In this way, the two shielding strips 1042a and 1042b may both obstruct the cathode material from forming a film on the two side walls of the groove 1020, thereby further ensuring that the adjacent cathode strips 1061 are partitioned by the partition groove 103.

The anode layer 104 is not limited to a specific material. In some embodiments, the anode layer 104 comprises a first indium tin oxide layer, a second indium tin oxide layer, and a silver layer sandwiched between the first indium tin oxide layer and the second indium tin oxide layer. The first indium tin oxide layer and the second indium tin oxide layer each has a thickness of 60 angstroms to 80 angstroms, for example 70 angstroms. The silver layer has a thickness of 800 angstroms to 1200 angstroms, for example 1000 angstroms. During the manufacturing of the anode layer 104, a film is formed first using a sputtering process, and then a pattern is formed by wet etching using a mask patterning process.

In some embodiments, the pattern of the organic layer 102 is formed by dry etching using a mask patterning process. Since the anode layer 104 pertains to an inorganic material which is very distinctive from the material of the organic layer 102, by dry etching the organic layer 102 by selecting a suitable selection ratio, an undercut structure is formed on one side of the two shielding strips 1042a and 1042b close to the substrate 101. That is, orthographic projections of the two shielding strips 1042a and 1042b on the substrate 101 partially overlap with the orthographic projection of the groove 1020 on the substrate 101. As shown in Fig. 1c, there is no gap between the orthographic projections of the two shielding strips 1042a and 1042b on the substrate 101 and the orthographic projection of the pixel defining layer 107 on the substrate 101. In other embodiments of the present disclosure, the orthographic projections of the two shielding strips on the substrate may also be spaced apart from or partially overlap with the orthographic projection of the pixel defining layer 107 on the substrate.

As shown in Fig. 1d, in some embodiments of the present disclosure, the width c of the orthographic projection of the groove 1020 on the substrate 101 along the first direction is 5 microns to 10 microns. The depth d of the groove 1020 along the direction perpendicular to the substrate 101 is 2 microns to 2.5 microns. The angle α between each of the two side walls 1020a and the bottom wall 1020b of the groove 1020 is 120° to 140°. The width S along the first direction of a portion of the orthographic projection of each of the shielding strips 1042a and 1042b on the substrate 101 overlapping with the orthographic projection of the corresponding groove 1020 on the substrate 101 is 0.8 micron to 1 micron. With the presence of the overlapped width S, the partition groove 103 has an undercut structure.

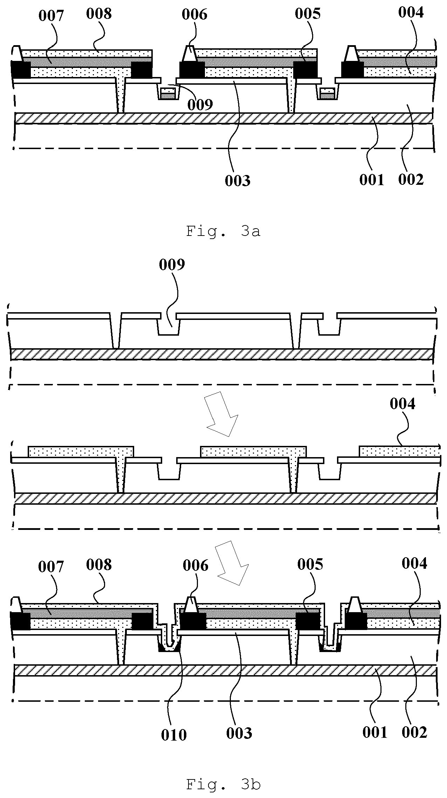

In a related technology, as shown in Fig. 3a, the structure of the passive matrix organic light-emitting display area in the organic light-emitting display substrate comprises a data metal layer 001, an organic layer 002, an inorganic layer 003, and an anode layer 004, a pixel defining layer 005, a spacer layer 006, an organic functional layer 007, and a cathode layer 008 arranged sequentially along a direction away from a substrate. The anode layer 004 is connected to the data metal layer 001 through a via hole, and the structure of a plurality of partition grooves 009 is formed by both the organic layer 002 and the inorganic layer 003. The plurality of partition grooves 009 are configured to partition the cathode layer 008 to obtain a plurality of cathode strips spaced apart along a row direction and extending along a column direction. When the organic light-emitting display substrate is manufactured, the partition groove 009 is formed first, and then the anode layer 004 is formed, and afterwards, the pixel defining layer 005, the spacer layer 006, the organic functional layer 007 and the cathode layer 008 are formed sequentially. The related technology has the following technical defects.
I. The organic layer 002 may release gas in a high-temperature process environment. The inorganic layer 003 covers a large area of the organic layer 002, which might result in that bubbles are generated between the organic layer 002 and the inorganic layer 003.
II. The inorganic layer 003 is formed on the surface of the organic layer 002. When the inorganic layer 003 is etched, it is likely to damage the organic layer 002.
III. The organic layer 002 is usually used as a planarization layer. The inorganic layer 003 manufactured on the surface of the organic layer 002 has poor planarization and is used as a base surface for manufacturing the anode layer 004.
IV. As shown in Fig. 3b, the manufacturing processes of the pixel defining layer 005 and the spacer layer 006 are performed after the manufacturing process of the partition groove 009 is completed. Thus, the manufacturing material 010 of the pixel defining layer and/or the spacer layer is likely to remain in the partition groove 009, a failure of the partition effect of the partition groove 009 is further resulted in, and the cathode strips cannot be effectively partitioned.
V. The manufacturing process of the anode layer 004 is performed after the manufacturing process of the partition groove 009. During the process of forming the anode layer 004 using a mask patterning process, bubbles might be generated between the photoresist layer and the inner wall of the partition groove 009. The explosion of the bubbles may have a bad effect on subsequent process.

The above technical defects have seriously affected the production yield of the organic light-emitting display substrate.

In the embodiments of the present disclosure, as shown in Fig. 1c, on one hand, since the anode layer 104 is formed on the surface of the organic layer 102 away from the substrate 101 and the structure of the partition groove 103 is formed by both the anode layer 104 and the organic layer 102, an inorganic layer is no longer provided between the anode layer 104 and the organic layer 102. Therefore, compared with the foregoing related technology, with the embodiments of the present disclosure, it is possible to overcome a series of problems resulting from the inorganic layer in the related technology. On the other hand, with the embodiments of the present disclosure, the structure of the partition groove 103 may be formed after the anode layer 104, the pixel defining layer 107, and the spacer layer 108 are formed. In this way, it is possible to avoid the failure of the partition groove resulting from the manufacturing material of the pixel defining layer and/or the spacer layer remaining in the partition groove, and occurrence of a bad effect on subsequent process resulting from residual bubbles. Therefore, the structural design of the organic light-emitting display substrate of the embodiments of the present disclosure is favorable for improving the production yield.

As shown in Fig. 1c, in some embodiments, the substrate 101 is a flexible substrate, which comprises a first organic flexible layer 101a, a second organic flexible layer 101c, and a first inorganic barrier layer 101b located between the first organic flexible layer 101a and the second organic flexible layer 101c. The material of each of the first organic flexible layer 101a and the second organic flexible layer 101c comprises polyimide, and the material of the first inorganic barrier layer 101b comprises silicon nitride. Such a design can not only improve the toughness of the substrate, but also facilitate to improve the encapsulation performance of the organic light-emitting display substrate. In other embodiments of the present disclosure, the substrate may also be a hard substrate.

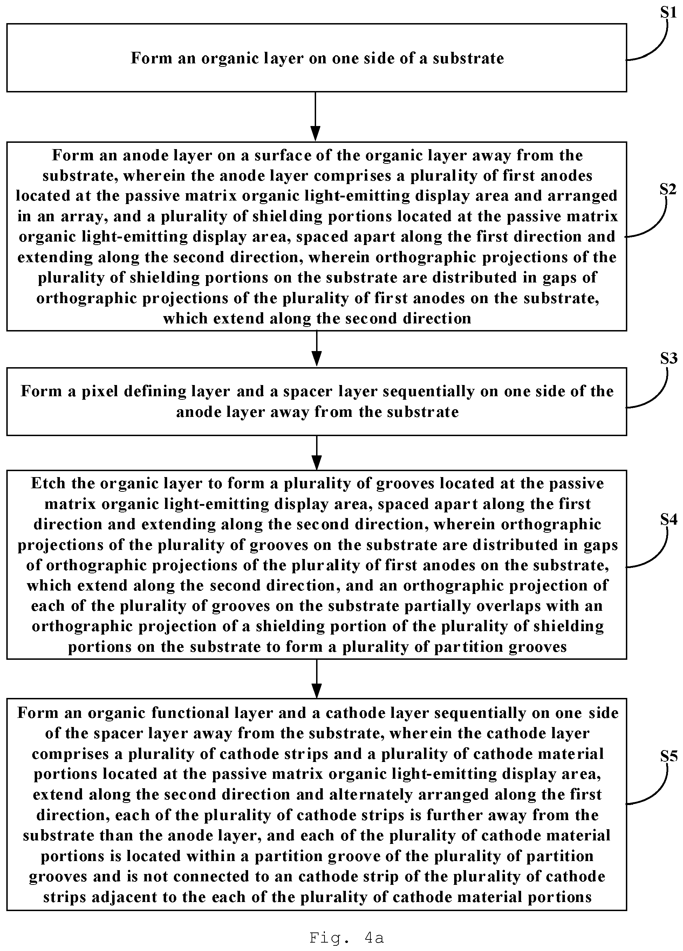

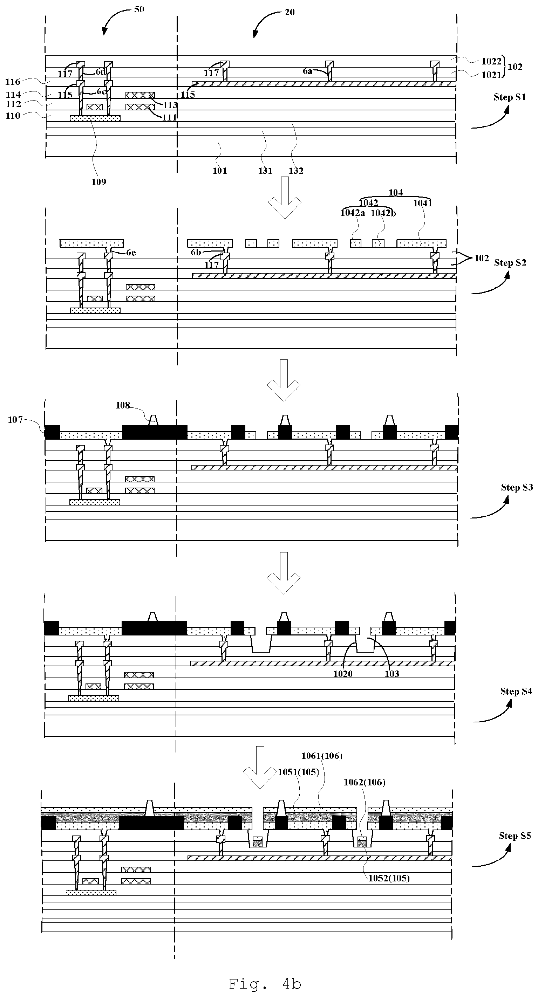

The embodiments of the present disclosure also provide a manufacturing method of an organic light-emitting display substrate, which may be applied to manufacturing of the foregoing organic light-emitting display substrate 1 which comprises the passive matrix organic light-emitting display area 20. As shown in Figs. 4a and 4b, the manufacturing method comprises the following steps S101 to S105.

At step S1, an organic layer 102 is formed on one side of a substrate 101.

At step S2, an anode layer 104 is formed on a surface of the organic layer 102 away from the substrate 101. The anode layer 104 comprises a plurality of first anodes 1041 located at the passive matrix organic light-emitting display area 20 and arranged in an array, and a plurality of shielding portions 1042 located at the passive matrix organic light-emitting display area 20, spaced apart along a first direction and extending along a second direction. The orthographic projections of the plurality of shielding portions 1042 on the substrate 101 are distributed in gaps of the orthographic projections of the plurality of first anodes 1041 on the substrate 101. The gaps extend along the second direction.

At step S3, a pixel defining layer 107 and a spacer layer 108 are formed sequentially on one side of the anode layer 104 away from the substrate 101.

At step S4, the organic layer 102 is etched to form a plurality of grooves 1020 located at the passive matrix organic light-emitting display area 20 and extending along the second direction. The orthographic projections of the plurality of grooves 1020 on the substrate 101 are distributed in the gaps of the orthographic projections of the plurality of first anodes 1041 on the substrate 101, the gaps extending along the second direction. Moreover, the orthographic projection of each groove 1020 on the substrate 101 partially overlaps with the orthographic projection of a shielding portion 1042 on the substrate 101 to form a partition groove 103.

At step S5, an organic functional layer 105 and a cathode layer 106 are formed sequentially on one side of the spacer layer 108 away from the substrate 101. The cathode layer 106 comprises a plurality of cathode strips 1061 and a plurality of cathode material portions 1062. The plurality of cathode strips 1061 and the plurality of cathode material portions 1062 are located at the passive matrix organic light-emitting display area 20, extend along the second direction and are alternately arranged along the first direction. Each cathode strip 1061 is further away from the substrate 101 than the anode layer 104, and each cathode material portion 1062 is located within a partition groove 103 and is not connected to a cathode strip 1061 adjacent to this cathode material portion 1062.

In some embodiments of the present disclosure, after the organic functional layer 105 is formed at step S5, the organic functional layer 105 is also discontinuous by being partitioned by the partition groove. As shown in Fig. 4b, the organic functional layer 105 comprises a plurality of first portions 1051 located at the passive matrix organic light-emitting display area 20 and a plurality of second portions 1052 located at the passive matrix organic light-emitting display area 20. Each first portion 1051 is further away from the substrate 101 than the anode layer 104, and each second portion 1052 is located within a partition groove 103 and is not connected to a first portion 1051 adjacent to this second portion 1052.

In some embodiments of the present disclosure, the substrate 101 is a flexible substrate and is formed on a glass substrate in advance (not shown). For example, a first organic flexible layer, a first inorganic barrier layer, and a second organic flexible layer are formed sequentially on one side of the glass substrate. The first organic flexible layer, the first inorganic barrier layer, and the second organic flexible layer as whole are the substrate of the organic light-emitting display substrate. The glass substrate produces a supporting effect during the manufacturing process of the organic light-emitting display substrate. After the manufacturing of the structure of the organic light-emitting display substrate is completed, the glass substrate is peeled off from the substrate to support the flexible characteristics of the organic light-emitting display substrate.

As shown in Fig. 4b, the above step of forming the organic layer 102 comprises forming a first organic layer 1021 and a second organic layer 1022 sequentially on one side of the substrate 101. In some embodiments, the groove 1020 penetrates through the second organic layer 1022 and extends into the first organic layer 1021. In other embodiments, the groove 1020 may not penetrate through the second organic layer 1022, that is, may stop within the second organic layer 1022. On such basis, the manufacturing method of the organic light-emitting display substrate further comprises following steps.

A first data metal layer 115 and a first inorganic layer 116 are formed sequentially on one side of the substrate 101 before the first organic layer 1021 is formed.

A second data metal layer 117 on one side of the first organic layer 1021 away from the substrate 101 is formed after the first organic layer 1021 is formed and before the second organic layer 1022 is formed. In the passive matrix organic light-emitting display area 20, the second data metal layer 117 is connected to the first data metal layer 115 through a plurality of first via holes 6a, and connected to the anode layer 104 through a plurality of second via holes 6b. Any two first anodes 1041 adjacent to each other along the first direction are connected to each other through the first data metal layer 115 or the second data metal layer 117.

As shown in Fig. 4b, other than the passive matrix organic light-emitting display area 20, the manufactured organic light-emitting display substrate also comprises an active matrix organic light-emitting display area 50. The manufacturing method of the organic light-emitting display substrate further comprises following step.

A semiconductor layer 109, a first insulating layer 110, a first gate metal layer 111, a second insulating layer 112, a second gate metal layer 113, a second gate metal layer 113 and a third insulating layer 114 are formed sequentially on one side of the substrate 101 before the first data metal layer 115 is formed. In the active matrix organic light-emitting display area 50, the first data metal layer 115 is connected to the semiconductor layer 109 through a plurality of third via holes 6c, the second data metal layer 117 is connected to the first data metal layer 115 through a plurality of fourth via holes 6d, and the anode layer 104 is connected to the second data metal layer 117 through a plurality of fifth via holes 6e.

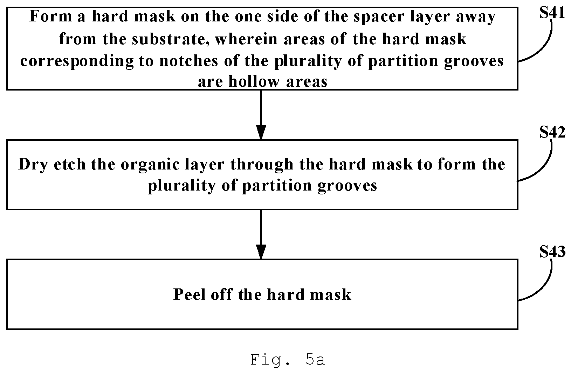

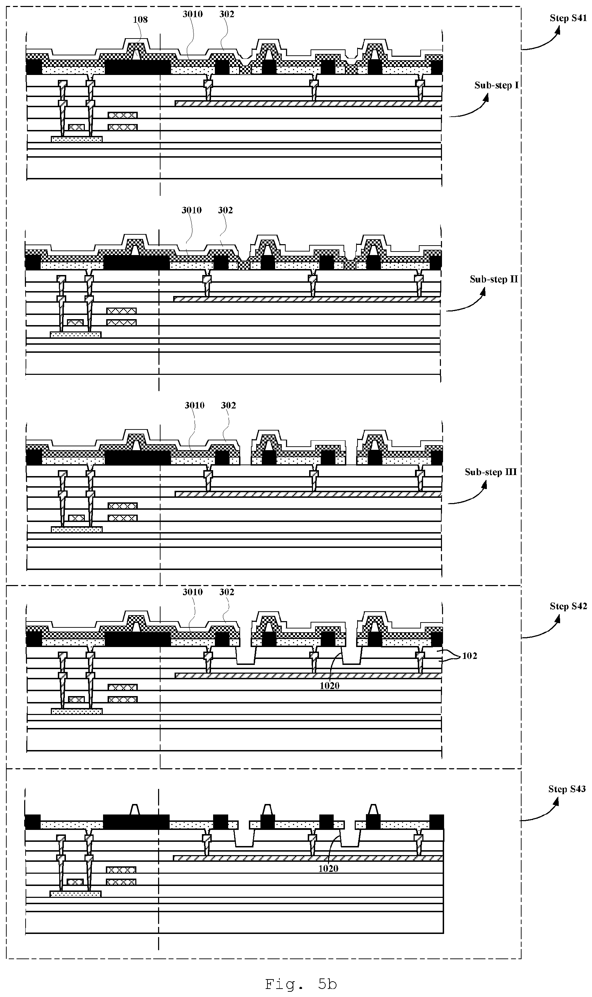

As shown in Figs. 5a and 5b, in some embodiments of the present disclosure, the step of etching the organic layer comprises the following steps S41 to S43.

At step S41, a hard mask is formed on one side of the spacer layer away from the substrate. An area of the hard mask corresponding to notch of the partition groove has is hollow area. The material type of the hard mask is not limited. In some embodiments, the material of the hard mask comprises metal oxides such as indium gallium zinc oxide.

As shown in Fig. 5b, in some embodiments, the step S41 specifically comprises following sub-steps.

Sub-step I: a hard mask cover layer 3010 and a photoresist cover layer 302 are formed sequentially on one side of the spacer layer 108 away from the substrate 101.

Sub-step II: the photoresist cover layer 302 is exposed and developed sequentially to obtain a photoresist protection mask. An area of the photoresist protection mask corresponding to notch of the partition groove is hollow area.

Sub-step III: the hard mask cover layer 3010 is wet etched through the photoresist protective mask to obtain the hard mask.

At step S42, the organic layer 102 is dry etched through the hard mask to form the plurality of grooves 1020.

At step S43, the hard mask is peeled off.

As mentioned above, since the anode layer is formed on the surface of the organic layer away from the substrate, the structure of the partition groove is formed by both the anode layer and the organic layer, and an inorganic layer is no longer provided between the anode layer and the organic layer. Therefore, compared with the foregoing related art, with the manufacturing method of the organic light-emitting display substrate of the embodiments of the present disclosure, it is possible to overcome a series of manufacturing problems resulting from the inorganic layer in the related art. In addition, the etching step for forming the partition groove is performed after the anode layer, the pixel defining layer, and the spacer layer are formed. Compared with the foregoing related technology, it is possible to avoid the failure of the partition groove resulting from the manufacturing material of the pixel defining layer and/or the spacer layer remaining in the partition groove, and the occurrence of bad effect on subsequent process resulting from residual bubbles. Therefore, with the manufacturing method of the organic light-emitting display substrate of the embodiments of the present disclosure, it is favorable for improving the production yield.

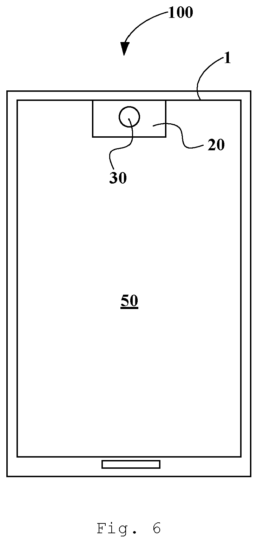

As shown in Fig. 6, the embodiments of the present disclosure also provide an organic light-emitting display device 100 which comprises the organic light-emitting display substrate 1 of any of the foregoing embodiments.

In some embodiments, the organic light-emitting display substrate 1 comprises a passive matrix organic light-emitting display area 20 and an active matrix organic light-emitting display area 50. The organic light-emitting display device 100 further comprises at least one functional device 30. The orthographic projection of the at least one functional device 30 on the display substrate 1 is located at the passive matrix organic light-emitting display area 20. The functional device 30 is not limited to a specific type, for example is a camera or a distance sensor.

The specific product types of the above organic light-emitting display devices comprise, but are not limited to, a mobile phone, a tablet computer, a notebook computer, a wearable device, an electronic paper or a display screen, and the like.

Since the organic light-emitting display substrate has the above beneficial effects, the organic light-emitting display device also has the above beneficial effects and higher production yield.

Hereto, various embodiments of the present disclosure have been described in detail. Some details well known in the art are not described to avoid obscuring the concept of the present disclosure. According to the above description, those skilled in the art would fully know how to implement the technical solutions disclosed herein.

Although some specific embodiments of the present disclosure have been described in detail by way of examples, those skilled in the art should understand that the above examples are only for the purpose of illustration and are not intended to limit the scope of the present disclosure. The scope of the disclosure is defined by the following claims.

## Claims

1. An organic light-emitting display substrate (1), comprising a passive matrix organic light-emitting display area (20), the organic light-emitting display substrate (1) comprising:
a substrate (101);
an organic layer (102) located on one side of the substrate (101), and comprising a plurality of grooves (1020) located at the passive matrix organic light-emitting display area (20), spaced apart along a first direction and extending along a second direction;
an anode layer (104) located on a surface of the organic layer (102) away from the substrate (101), and comprising
a plurality of first anodes (1041) located at the passive matrix organic light-emitting display area (20) and arranged in an array, and
a plurality of shielding portions (1042) located at the passive matrix organic light-emitting display area (20), spaced apart along the first direction and extending along the second direction, wherein orthographic projections of the plurality of shielding portions (1042) on the substrate (101) and orthographic projections of the plurality of grooves (1020) on the substrate (101) are distributed in gaps of orthographic projections of the plurality of first anodes (1041) on the substrate (101), which extend along the second direction, and an orthographic projection of each of the plurality of shielding portions (1042) on the substrate (101) partially overlaps with an orthographic projection of a groove (1020) of the plurality of grooves (1020) on the substrate (101) to form a plurality of partition grooves (103);
an organic functional layer (105) located on one side of the anode layer (104) away from the substrate (101); and
a cathode layer (106) located on one side of the organic functional layer (105) away from the substrate (101), and comprising a plurality of cathode strips (1061) and a plurality of cathode material portions (1062), wherein the plurality of cathode strips (1061) and the plurality of cathode material portions (1062) are located at the passive matrix organic light-emitting display area (20), extend along the second direction and are alternately arranged along the first direction, each of the plurality of cathode strips (1061) is further away from the substrate (101) than the anode layer (104), and each of the plurality of cathode material portions (1062) is located within a partition groove (103) of the plurality of partition grooves (103) and is not connected to an cathode strip (1061) of the plurality of cathode strips (1061) adjacent to the each of the plurality of cathode material portions (1062);
**characterized in that**
a material of a shielding portion (1042) is the same as a material of a first anode (1041) and spaced apart from the first anode (1041) by a pixel defining layer (107).

2. The organic light-emitting display substrate (1) according to claim 1, wherein the organic functional layer (105) comprises a plurality of first portions (1051) located at the passive matrix organic light-emitting display area (20) and a plurality of second portions (1052) located at the passive matrix organic light-emitting display area (20), wherein each of the plurality of first portions (1051) is further away from the substrate (101) than the anode layer (104), and each of the plurality of second portions (1052) is located within a partition groove (103) of the plurality of partition grooves (103) and is not connected to a first portion (1051) of the plurality of first portions (1051) adjacent to the each of the plurality of second portions (1052).

3. The organic light-emitting display substrate (1) according to claim 1, wherein each of the plurality of shielding portions (1042) comprises two shielding strips (1042a, 1042b) located on both sides of the groove (1020) and spaced apart from each other, and an orthographic projection of each of the two shielding strips (1042a, 1042b) on the substrate (101) partially overlaps with the orthographic projection of the groove (1020) on the substrate (101).

4. The organic light-emitting display substrate (1) according to claim 3, further comprising a first data metal layer (115), a first inorganic layer (116), a second data metal layer (117), the pixel defining layer (107) and a spacer layer (108) on the one side of the substrate (101), wherein:
the organic layer (102) comprises a first organic layer (1021) and a second organic layer (1022);
the first data metal layer (115), the first inorganic layer (116), the first organic layer (1021), the second data metal layer (117), the second organic layer (1022), the anode layer (104), the pixel defining layer (107), the spacer layer (108), the organic functional layer (105) and the cathode layer (106) are arranged sequentially along a direction away from the substrate (101); and
in the passive matrix organic light-emitting display area (20), the second data metal layer (117) is connected to the first data metal layer (115) through a plurality of first via holes (6a) and connected to the anode layer (104) through a plurality of second via holes (6b), and any two of the plurality of first anodes (1041) adjacent to each other along the first direction are connected to each other through the first data metal layer (115) or the second data metal layer (117).

5. The organic light-emitting display substrate (1) according to claim 4, wherein each of the plurality of grooves (1020) penetrates through the second organic layer (1022) and extends into the first organic layer (1021).

6. The organic light-emitting display substrate (1) according to claim 4, wherein an orthographic projection of each of the plurality of grooves (1020) on the substrate (101) has a width of 5 microns to 10 microns along the first direction.

7. The organic light-emitting display substrate (1) according to claim 4, wherein each of the plurality of grooves (1020) on the substrate (101) has a depth of 2 micrometers to 2.5 micrometers along a direction perpendicular to the substrate (101).

8. The organic light-emitting display substrate (1) according to claim 4, wherein an angle between each of two side walls (1020a) and a bottom wall (1020b) of each of the plurality of grooves (1020) is 120 degrees to 140 degrees.

9. The organic light-emitting display substrate (1) according to claim 4, wherein a portion of the orthographic projection of each of the two shielding strips (1042a, 1042b) on the substrate (101) overlapping with the orthographic projection of the groove (1020) on the substrate (101) has a width of 0.8 micron to 1 micron along the first direction.

10. The organic light-emitting display substrate (1) according to claim 4, further comprising an active matrix organic light-emitting display area (50), the organic light-emitting display substrate (1) further comprising a semiconductor layer (109), a first insulating layer (110), a first gate metal layer (111), a second insulating layer (112), a second gate metal layer (113) and a third insulating layer (114) which are located between the substrate (101) and the first data metal layer (115) and arranged sequentially along the direction away from the substrate (101), wherein:
in the active matrix organic light-emitting display area (50), the first data metal layer (115) is connected to the semiconductor layer (109) through a plurality of third via holes (6c) and connected to the second data metal layer (117) through a plurality of fourth via holes (6d), and
the anode layer (104) is connected to the second data metal layer (117) through a plurality of fifth via holes (6e)
optionally, wherein the active matrix organic light-emitting display area (50) surrounds a portion of an edge of the passive matrix organic light-emitting display area (20); or the active matrix organic light-emitting display area (50) surrounds the edge of the passive matrix organic light-emitting display area (20).

11. The organic light-emitting display substrate (1) according to any one of claims 1-10, wherein the substrate (101) comprises a first organic flexible layer (101a), a second organic flexible layer (101c), and a first inorganic barrier layer (101b) located between the first organic flexible layer (101a) and the second organic flexible layer (101c).

12. An organic light-emitting display device (100), **characterized by** comprising the organic light-emitting display substrate (1) according to any one of claims 1-11;
optionally, wherein:
the organic light-emitting display substrate (1) further comprises an active matrix organic light-emitting display area (50); and
the organic light-emitting display device (100) further comprises at least one functional device (30), an orthographic projection of which on the organic light-emitting display substrate (1) is located at the passive matrix organic light-emitting display area (20).

13. A manufacturing method of an organic light-emitting display substrate (1) comprising a passive matrix organic light-emitting display area (20), the manufacturing method comprising:
forming (S1) an organic layer (102) on one side of a substrate (101);
forming (S2) an anode layer (104) on a surface of the organic layer (102) away from the substrate (101), wherein the anode layer (104) comprises
a plurality of first anodes (1041) located at the passive matrix organic light-emitting display area (20) and arranged in an array, and
a plurality of shielding portions (1042) located at the passive matrix organic light-emitting display area (20), spaced apart along the first direction and extending along the second direction, wherein orthographic projections of the plurality of shielding portions (1042) on the substrate (101) are distributed in gaps of orthographic projections of the plurality of first anodes (1041) on the substrate (101), which extend along the second direction;
forming (S3) a pixel defining layer (107) and a spacer layer (108) sequentially on one side of the anode layer (104) away from the substrate (101);
etching (S4) the organic layer (102) to form a plurality of grooves (1020) located at the passive matrix organic light-emitting display area (20), spaced apart along the first direction and extending along the second direction, wherein orthographic projections of the plurality of grooves (1020) on the substrate (101) are distributed in gaps of orthographic projections of the plurality of first anodes (1041) on the substrate (101), which extend along the second direction, and an orthographic projection of each of the plurality of grooves (1020) on the substrate (101) partially overlaps with an orthographic projection of a shielding portion of the plurality of shielding portions (1042) on the substrate (101) to form a plurality of partition grooves (103); and
forming (S5) an organic functional layer (105) and a cathode layer (106) sequentially on one side of the spacer layer (108) away from the substrate (101), wherein the cathode layer (106) comprises a plurality of cathode strips (1061) and a plurality of cathode material portions (1062), the plurality of cathode strips (1061) and the plurality of cathode material portions (1062) are located at the passive matrix organic light-emitting display area (20), extend along the second direction and are alternately arranged along the first direction, each of the plurality of cathode strips (1061) is further away from the substrate (101) than the anode layer (104), and each of the plurality of cathode material portions (1062) is located within a partition groove (103) of the plurality of partition grooves (103) and is not connected to an cathode strip (1061) of the plurality of cathode strips (1061) adjacent to the each of the plurality of cathode material portions (1062),
**characterized in that**
a material of a shielding portion (1042) is the same as a material of a first anode (1041) and spaced apart from the first anode (1041) by the pixel defining layer (107).

14. The manufacturing method according to claim 13, wherein etching the organic layer (102) comprises:
forming (S41) a hard mask on the one side of the spacer layer (108) away from the substrate (101), wherein areas of the hard mask corresponding to notches of the plurality of partition grooves (103) are hollow areas;
dry etching (S42) the organic layer (102) through the hard mask to form the plurality of partition grooves (103); and
peeling off (S43) the hard mask;
optionally, wherein forming the hard mask comprises:
forming a hard mask cover layer (3010) and a photoresist cover layer (302) sequentially on the one side of the spacer layer (108) away from the substrate (101);
exposing and developing the photoresist cover layer (302) sequentially to obtain a photoresist protection mask, wherein areas of the photoresist protection mask corresponding to the notches of the plurality of partition grooves (103) are hollow areas; and
wet etching the hard mask cover layer (3010) through the photoresist protective mask to obtain the hard mask;
optionally, wherein a material of the hard mask comprises metal oxide;
optionally, wherein a material of the hard mask comprises indium gallium zinc oxide.

15. The manufacturing method according to any one of claims 13-14, wherein forming the organic layer (102) comprises forming a first organic layer (1021) and a second organic layer (1022) sequentially on the one side of the substrate (101), and the manufacturing method further comprises:
forming a first data metal layer (115) and a first inorganic layer (116) sequentially on the one side of the substrate (101) before forming the first organic layer (1021); and
forming a second data metal layer (117) on one side of the first organic layer (1021) away from the substrate (101) after forming the first organic layer (1021) and before forming the second organic layer (1022),
wherein in the passive matrix organic light-emitting display area (20), the second data metal layer (117) is connected to the first data metal layer (115) through a plurality of first via holes (6a) and connected to the anode layer (104) through a plurality of second via holes (6b), and any two of the plurality of first anodes (1041) adjacent to each other along the first direction are connected to each other through the first data metal layer (115) or the second data metal layer (117);
optionally, wherein each of the plurality of grooves (1020) penetrates through the second organic layer (1022) and extends into the first organic layer (1021);
optionally, wherein the organic light-emitting display substrate (1) further comprises an active matrix organic light-emitting display area (50), and the manufacturing method further comprises:
forming a semiconductor layer (109), a first insulating layer (110), a first gate metal layer (111), a second insulating layer (112), a second gate metal layer (113), and a third insulating layer (114) sequentially on the one side of the substrate (101) before forming the first data metal layer (115), wherein in the active matrix organic light-emitting display area (50), the first data metal layer (115) is connected to the semiconductor layer (109) through a plurality of third via holes (6c) and connected to the second data metal layer (117) through a plurality of fourth via holes (6d), and the anode layer (104) is connected to the second data metal layer (117) through a plurality of fifth via holes (6e).

## Patentansprüche

1. Organisches lichtemittierendes Anzeigesubstrat (1), umfassend einen organischen lichtemittierenden Anzeigebereich (20) mit passiver Matrix, wobei das organische lichtemittierende Anzeigesubstrat (1) umfasst:
ein Substrat (101);
eine organische Schicht (102), die sich auf einer Seite des Substrats (101) befindet und eine Vielzahl von Nuten (1020) umfasst, die sich im organischen lichtemittierenden Anzeigebereich (20) mit passiver Matrix befinden, entlang einer ersten Richtung voneinander beabstandet sind und sich entlang einer zweiten Richtung erstrecken;
eine Anodenschicht (104), die sich auf einer vom Substrat (101) weg gerichteten Oberfläche der organischen Schicht (102) befindet und
eine Vielzahl von ersten Anoden (1041), die sich in dem organischen lichtemittierenden Anzeigebereich (20) mit passiver Matrix befinden und in einem Array angeordnet sind, und
eine Vielzahl von Abschirmabschnitten (1042) umfasst, die sich im organischen lichtemittierenden Anzeigebereich (20) mit passiver Matrix befinden, entlang der ersten Richtung voneinander beabstandet sind und sich entlang der zweiten Richtung erstrecken, wobei orthografische Projektionen der Vielzahl von Abschirmabschnitten (1042) auf dem Substrat (101) und orthografische Projektionen der Vielzahl von Nuten (1020) auf dem Substrat (101) in Lücken orthografischer Projektionen der Vielzahl von ersten Anoden (1041) auf dem Substrat (101) verteilt sind, die sich entlang der zweiten Richtung erstrecken, und eine orthografische Projektion jedes der Vielzahl von Abschirmabschnitten (1042) auf dem Substrat (101) sich teilweise mit einer orthografischen Projektion einer Nut (1020) der Vielzahl von Nuten (1020) auf dem Substrat (101) überlappt, um eine Vielzahl von Unterteilungsnuten (103) zu bilden;
eine organische Funktionsschicht (105), die sich auf einer Seite der vom Substrat (101) weg gerichteten Anodenschicht (104) befindet; und
eine Kathodenschicht (106), die sich auf einer Seite der vom Substrat (101) weg gerichteten organischen Funktionsschicht (105) befindet und eine Vielzahl von Kathodenstreifen (1061) und eine Vielzahl von Kathodenmaterialabschnitten (1062) umfasst, wobei sich die Vielzahl von Kathodenstreifen (1061) und die Vielzahl von Kathodenmaterialabschnitten (1062) im organischen lichtemittierenden Anzeigebereich (20) mit passiver Matrix befinden, sich entlang der zweiten Richtung erstrecken und abwechselnd entlang der ersten Richtung angeordnet sind, wobei jeder der Vielzahl von Kathodenstreifen (1061) weiter vom Substrat (101) entfernt ist als die Anodenschicht (104) und sich jeder der Vielzahl von Kathodenmaterialabschnitten (1062) innerhalb einer Unterteilungsnut (103) der Vielzahl von Unterteilungsnuten (103) befindet und nicht mit einem Kathodenstreifen (1061) der Vielzahl von Kathodenstreifen (1061) verbunden ist, der an jeden der Vielzahl von Kathodenmaterialabschnitten (1062) angrenzt;
**dadurch gekennzeichnet, dass**
ein Material eines Abschirmabschnitts (1042) dasselbe ist wie ein Material einer ersten Anode (1041) und von der ersten Anode (1041) durch eine pixeldefinierende Schicht (107) beabstandet ist.

2. Organisches lichtemittierendes Anzeigesubstrat (1) nach Anspruch 1, wobei die organische Funktionsschicht (105) eine Vielzahl von ersten Abschnitten (1051), die sich im organischen lichtemittierenden Anzeigebereich (20) mit passiver Matrix befinden, und eine Vielzahl von zweiten Abschnitten (1052) umfasst, die sich im organischen lichtemittierenden Anzeigebereich (20) mit passiver Matrix befinden, wobei jeder der Vielzahl von ersten Abschnitten (1051) weiter vom Substrat (101) entfernt ist als die Anodenschicht (104) und jeder der Vielzahl von zweiten Abschnitten (1052) sich innerhalb einer Unterteilungsnut (103) der Vielzahl von Unterteilungsnuten (103) befindet und nicht mit einem ersten Abschnitt (1051) der Vielzahl von ersten Abschnitten (1051) verbunden ist, der an jeden der Vielzahl von zweiten Abschnitten (1052) angrenzt.

3. Organisches lichtemittierendes Anzeigesubstrat (1) nach Anspruch 1, wobei jeder der Vielzahl von Abschirmabschnitten (1042) zwei Abschirmstreifen (1042a, 1042b) umfasst, die sich auf beiden Seiten der Nut (1020) befinden und voneinander beabstandet sind, und sich eine orthografische Projektion jedes der beiden Abschirmstreifen (1042a, 1042b) auf dem Substrat (101) teilweise mit der orthografischen Projektion der Nut (1020) auf dem Substrat (101) überlappt.

4. Organisches lichtemittierendes Anzeigesubstrat (1) nach Anspruch 3, weiter umfassend eine erste Datenmetallschicht (115), eine erste anorganische Schicht (116), eine zweite Datenmetallschicht (117), die pixeldefinierende Schicht (107) und eine Abstandsschicht (108) auf der einen Seite des Substrats (101), wobei:
die organische Schicht (102) eine erste organische Schicht (1021) und eine zweite organische Schicht (1022) umfasst;
die erste Datenmetallschicht (115), die erste anorganische Schicht (116), die erste organische Schicht (1021), die zweite Datenmetallschicht (117), die zweite organische Schicht (1022), die Anodenschicht (104), die pixeldefinierende Schicht (107), die Abstandsschicht (108), die organische Funktionsschicht (105) und die Kathodenschicht (106) nacheinander entlang einer vom Substrat (101) weg gerichteten Richtung angeordnet sind; und
im organischen lichtemittierenden Anzeigebereich (20) mit passiver Matrix die zweite Datenmetallschicht (117) durch eine Vielzahl von ersten Durchkontaktierungslöchern (6a) mit der ersten Datenmetallschicht (115) verbunden ist und durch eine Vielzahl von zweiten Durchkontaktierungslöchern (6b) mit der Anodenschicht (104) verbunden ist, und zwei beliebige der Vielzahl von ersten Anoden (1041) nebeneinander entlang der ersten Richtung durch die erste Datenmetallschicht (115) oder die zweite Datenmetallschicht (117) miteinander verbunden sind.

5. Organisches lichtemittierendes Anzeigesubstrat (1) nach Anspruch 4, wobei jede der Vielzahl von Nuten (1020) durch die zweite organische Schicht (1022) dringt und sich in die erste organische Schicht (1021) erstreckt.

6. Organisches lichtemittierendes Anzeigesubstrat (1) nach Anspruch 4, wobei eine orthografische Projektion jeder der Vielzahl von Nuten (1020) auf dem Substrat (101) eine Breite von 5 Mikrometern bis 10 Mikrometern entlang der ersten Richtung aufweist.

7. Organisches lichtemittierendes Anzeigesubstrat (1) nach Anspruch 4, wobei jede der Vielzahl von Nuten (1020) auf dem Substrat (101) eine Tiefe von 2 Mikrometern bis 2,5 Mikrometern entlang einer Richtung senkrecht zum Substrat (101) aufweist.

8. Organisches lichtemittierendes Anzeigesubstrat (1) nach Anspruch 4, wobei ein Winkel zwischen jeder von zwei Seitenwänden (1020a) und einer Bodenwand (1020b) jeder der Vielzahl von Nuten (1020) 120 Grad bis 140 Grad beträgt.

9. Organisches lichtemittierendes Anzeigesubstrat (1) nach Anspruch 4, wobei ein Abschnitt der orthografischen Projektion jedes der beiden Abschirmstreifen (1042a, 1042b) auf dem Substrat (101), der sich mit der orthografischen Projektion der Nut (1020) auf dem Substrat (101) überlappt, eine Breite von 0,8 Mikrometern bis 1 Mikrometer entlang der ersten Richtung aufweist.

10. Organisches lichtemittierendes Anzeigesubstrat (1) nach Anspruch 4, weiter umfassend einen organischen lichtemittierenden Anzeigebereich (50) mit aktiver Matrix, wobei das organische lichtemittierende Anzeigesubstrat (1) weiter eine Halbleiterschicht (109), eine erste Isolierschicht (110), eine erste Gate-Metallschicht (111), eine zweite Isolierschicht (112), eine zweite Gate-Metallschicht (113) und eine dritte Isolierschicht (114) umfasst, die sich zwischen dem Substrat (101) und der ersten Datenmetallschicht (115) befinden und nacheinander entlang der vom Substrat (101) weg gerichteten Richtung angeordnet sind, wobei:
im organischen lichtemittierenden Anzeigebereich (50) mit aktiver Matrix die erste Datenmetallschicht (115) durch eine Vielzahl von dritten Durchkontaktierungslöchern (6c) mit der Halbleiterschicht (109) verbunden ist und durch eine Vielzahl von vierten Durchkontaktierungslöchern (6d) mit der zweiten Datenmetallschicht (117) verbunden ist, und
die Anodenschicht (104) über eine Vielzahl von fünften Durchkontaktierungslöchern (6e) mit der zweiten Datenmetallschicht (117) verbunden ist,
wobei der organische lichtemittierende Anzeigebereich (50) mit aktiver Matrix optional einen Abschnitt eines Randes des organischen lichtemittierenden Anzeigebereichs (20) mit passiver Matrix umgibt; oder der organische lichtemittierende Anzeigebereich (50) mit aktiver Matrix den Rand des organischen lichtemittierenden Anzeigebereichs (20) mit passiver Matrix umgibt.

11. Organisches lichtemittierendes Anzeigesubstrat (1) nach einem der Ansprüche 1-10, wobei das Substrat (101) eine erste flexible organische Schicht (101a), eine zweite flexible organische Schicht (101c) und eine erste anorganische Barriereschicht (101b) umfasst, die sich zwischen der ersten flexiblen organischen Schicht (101a) und der zweiten flexiblen organischen Schicht (101c) befindet.

12. Organische lichtemittierende Anzeigevorrichtung (100), **dadurch gekennzeichnet, dass** sie das organische lichtemittierende Anzeigesubstrat (1) nach einem der Ansprüche 1 bis 11 umfasst;
wobei optional:
das organische lichtemittierende Anzeigesubstrat (1) weiter einen organischen lichtemittierenden Anzeigebereich (50) mit aktiver Matrix umfasst; und
die organische lichtemittierende Anzeigevorrichtung (100) weiter mindestens eine Funktionsvorrichtung (30) umfasst, deren orthografische Projektion sich auf dem organischen lichtemittierenden Anzeigesubstrat (1) im organischen lichtemittierenden Anzeigebereich (20) mit passiver Matrix befindet.

13. Herstellungsverfahren für ein organisches lichtemittierendes Anzeigesubstrat (1), das einen organischen lichtemittierenden Anzeigebereich (20) mit passiver Matrix umfasst, wobei das Herstellungsverfahren umfasst:
Bilden (S1) einer organischen Schicht (102) auf einer Seite eines Substrats (101);
Bilden (S2) einer Anodenschicht (104) auf einer vom Substrat (101) weg gerichteten Oberfläche der organischen Schicht (102), wobei die Anodenschicht (104)
eine Vielzahl von ersten Anoden (1041), die sich in dem organischen lichtemittierenden Anzeigebereich (20) mit passiver Matrix befinden und in einem Array angeordnet sind, und
eine Vielzahl von Abschirmabschnitten (1042) umfasst, die sich im organischen lichtemittierenden Anzeigebereich (20) mit passiver Matrix befinden, entlang der ersten Richtung voneinander beabstandet sind und sich entlang der zweiten Richtung erstrecken, wobei orthografische Projektionen der Vielzahl von Abschirmabschnitten (1042) auf dem Substrat (101) in Lücken der orthografischen Projektionen der Vielzahl von ersten Anoden (1041) auf dem Substrat (101) verteilt sind, die sich entlang der zweiten Richtung erstrecken;
Bilden (S3) einer pixeldefinierenden Schicht (107) und einer Abstandsschicht (108) nacheinander auf einer vom Substrat (101) weg gerichteten Seite der Anodenschicht (104);
Ätzen (S4) der organischen Schicht (102), um eine Vielzahl von Nuten (1020) zu bilden, die sich im organischen lichtemittierenden Anzeigebereich (20) mit passiver Matrix befinden, entlang der ersten Richtung beabstandet sind und sich entlang der zweiten Richtung erstrecken, wobei orthografische Projektionen der Vielzahl von Nuten (1020) auf dem Substrat (101) in Lücken der orthografischen Projektionen der Vielzahl von ersten Anoden (1041) auf dem Substrat (101) verteilt sind, die sich entlang der zweiten Richtung erstrecken, und sich eine orthografische Projektion jeder der Vielzahl von Nuten (1020) auf dem Substrat (101) teilweise mit einer orthografischen Projektion eines Abschirmabschnitts der Vielzahl von Abschirmabschnitten (1042) auf dem Substrat (101) überlappt, um eine Vielzahl von Unterteilungsnuten (103) zu bilden; und
Bilden (S5) einer organischen Funktionsschicht (105) und einer Kathodenschicht (106) nacheinander auf einer vom Substrat (101) weg gerichteten Seite der Abstandsschicht (108), wobei die Kathodenschicht (106) eine Vielzahl von Kathodenstreifen (1061) und eine Vielzahl von Kathodenmaterialabschnitten (1062) umfasst, wobei die Vielzahl von Kathodenstreifen (1061) und sich die Vielzahl von Kathodenmaterialabschnitten (1062) im organischen lichtemittierenden Anzeigebereich (20) mit passiver Matrix befinden, sich entlang der zweiten Richtung erstrecken und abwechselnd entlang der ersten Richtung angeordnet sind, wobei jeder der Vielzahl von Kathodenstreifen (1061) weiter vom Substrat (101) entfernt ist als die Anodenschicht (104), und sich jeder der Vielzahl von Kathodenmaterialabschnitten (1062) innerhalb einer Unterteilungsnut (103) der Vielzahl von Unterteilungsnuten (103) befindet und nicht mit einem Kathodenstreifen (1061) der Vielzahl von Kathodenstreifen (1061) verbunden ist, der an jeden der Vielzahl von Kathodenmaterialabschnitten (1062) angrenzt,
**dadurch gekennzeichnet, dass**
ein Material eines Abschirmabschnitts (1042) dasselbe ist wie ein Material einer ersten Anode (1041) und von der ersten Anode (1041) durch die pixeldefinierende Schicht (107) beabstandet ist.

14. Herstellungsverfahren nach Anspruch 13, wobei das Ätzen der organischen Schicht (102) umfasst:
Bilden (S41) einer Hartmaske auf der einen vom Substrat (101) weg gerichteten Seite der Abstandsschicht (108), wobei Bereiche der Hartmaske, die Kerben der Vielzahl von Unterteilungsnuten (103) entsprechen, Hohlbereiche sind;
Trockenätzen (S42) der organischen Schicht (102) durch die Hartmaske hindurch, um die Vielzahl von Unterteilungsnuten (103) zu bilden; und
Abziehen (S43) der Hartmaske;
wobei das Bilden der Hartmaske optional umfasst:
Bilden einer Hartmasken-Deckschicht (3010) und einer Fotolack-Deckschicht (302) nacheinander auf der einen vom Substrat (101) weg gerichteten Seite der Abstandsschicht (108);
nacheinander Belichten und Entwickeln der Fotolack-Deckschicht (302), um eine Fotolack-Schutzmaske zu erhalten, wobei Bereiche der Fotolack-Schutzmaske, die den Kerben der Vielzahl von Unterteilungsnuten (103) entsprechen, Hohlbereiche sind; und
Nassätzen der Hartmasken-Deckschicht (3010) durch die Fotolack-Schutzmaske hindurch, um die Hartmaske zu erhalten;
wobei ein Material der Hartmaske optional Metalloxid umfasst;
wobei ein Material der Hartmaske optional Indium-Gallium-Zinkoxid umfasst.

15. Herstellungsverfahren nach einem der Ansprüche 13 bis 14, wobei das Bilden der organischen Schicht (102) nacheinander das Bilden einer ersten organischen Schicht (1021) und einer zweiten organischen Schicht (1022) auf der einen Seite des Substrats (101) umfasst, und das Herstellungsverfahren ferner umfasst:
Bilden einer ersten Datenmetallschicht (115) und einer ersten anorganischen Schicht (116) nacheinander auf der einen Seite des Substrats (101), bevor die erste organische Schicht (1021) gebildet wird; und
Bilden einer zweiten Datenmetallschicht (117) auf einer vom Substrat (101) weg gerichteten Seite der ersten organischen Schicht (1021), nachdem die erste organische Schicht (1021) gebildet wurde und bevor die zweite organische Schicht (1022) gebildet wird,
wobei im organischen lichtemittierenden Anzeigebereich (20) mit passiver Matrix die zweite Datenmetallschicht (117) durch eine Vielzahl von ersten Durchkontaktierungslöchern (6a) mit der ersten Datenmetallschicht (115) verbunden ist und durch eine Vielzahl von zweiten Durchkontaktierungslöchern (6b) mit der Anodenschicht (104) verbunden ist, und zwei beliebige der Vielzahl von ersten Anoden (1041) nebeneinander entlang der ersten Richtung durch die erste Datenmetallschicht (115) oder die zweite Datenmetallschicht (117) miteinander verbunden sind;
wobei jede der Vielzahl von Nuten (1020) durch die zweite organische Schicht (1022) dringt und sich in die erste organische Schicht (1021) erstreckt;
wobei das organische lichtemittierende Anzeigesubstrat (1) weiter einen organischen lichtemittierenden Anzeigebereich (50) mit aktiver Matrix umfasst, und das Herstellungsverfahren weiter umfasst:
Bilden einer Halbleiterschicht (109), einer ersten Isolierschicht (110), einer ersten Gate-Metallschicht (111), einer zweiten Isolierschicht (112), einer zweiten Gate-Metallschicht (113) und einer dritten Isolierschicht (114) nacheinander auf der einen Seite des Substrats (101), vor dem Bilden der ersten Datenmetallschicht (115), wobei im organischen lichtemittierenden Anzeigebereich (50) mit aktiver Matrix die erste Datenmetallschicht (115) durch eine Vielzahl von dritten Durchkontaktierungslöchern (6c) mit der Halbleiterschicht (109) verbunden ist und durch eine Vielzahl von vierten Durchkontaktierungslöchern (6d) mit der zweiten Datenmetallschicht (117) verbunden ist, und die Anodenschicht (104) durch eine Vielzahl von fünften Durchkontaktierungslöchern (6e) mit der zweiten Datenmetallschicht (117) verbunden ist.

## Revendications

1. Substrat d'affichage électroluminescent organique (1), comportant une zone d'affichage électroluminescent organique à matrice passive (20), le substrat d'affichage électroluminescent organique (1) comportant :
un substrat (101) ;
une couche organique (102) située d'un côté du substrat (101), et comportant une pluralité de rainures (1020) situées au niveau de la zone d'affichage électroluminescent organique à matrice passive (20), espacées le long d'une première direction et s'étendant le long d'une deuxième direction ;
une couche d'anode (104) située sur une surface de la couche organique (102) à l'écart du substrat (101), et comportant
une pluralité de premières anodes (1041) situées au niveau de la zone d'affichage électroluminescent organique à matrice passive (20) et agencées en un réseau, et
une pluralité de parties de blindage (1042) situées au niveau de la zone d'affichage électroluminescent organique à matrice passive (20), espacées le long de la première direction et s'étendant le long de la deuxième direction, dans lequel des projections orthographiques de la pluralité de parties de blindage (1042) sur le substrat (101) et des projections orthographiques de la pluralité de rainures (1020) sur le substrat (101) sont réparties dans des espaces de projections orthographiques de la pluralité de premières anodes (1041) sur le substrat (101), qui s'étendent le long de la deuxième direction, et une projection orthographique de chacune de la pluralité de parties de blindage (1042) sur le substrat (101) chevauche partiellement une projection orthographique d'une rainure (1020) de la pluralité de rainures (1020) sur le substrat (101) pour former une pluralité de rainures de séparation (103) ;
une couche fonctionnelle organique (105) située d'un côté de la couche d'anode (104) à l'écart du substrat (101) ; et
une couche de cathode (106) située d'un côté de la couche fonctionnelle organique (105) à l'écart du substrat (101), et comportant une pluralité de bandes de cathode (1061) et une pluralité de parties de matériau de cathode (1062), dans lequel la pluralité de bandes de cathode (1061) et la pluralité de parties de matériau de cathode (1062) sont situées au niveau de la zone d'affichage électroluminescent organique à matrice passive (20), s'étendent le long de la deuxième direction et sont agencées alternativement le long de la première direction, chacune de la pluralité de bandes de cathode (1061) est plus éloignée du substrat (101) que ne l'est la couche d'anode (104), et chacune de la pluralité de parties de matériau de cathode (1062) est située à l'intérieur d'une rainure de séparation (103) de la pluralité de rainures de séparation (103) et n'est pas reliée à une bande de cathode (1061) de la pluralité de bandes de cathode (1061) adjacentes à chacune de la pluralité de parties de matériau de cathode (1062) ;
**caractérisé en ce que**
un matériau d'une partie de blindage (1042) est le même qu'un matériau d'une première anode (1041) et espacé de la première anode (1041) par une couche de définition de pixels (107).

2. Substrat d'affichage électroluminescent organique (1) selon la revendication 1, dans lequel la couche fonctionnelle organique (105) comporte une pluralité de premières parties (1051) situées au niveau de la zone d'affichage électroluminescent organique à matrice passive (20) et une pluralité de deuxièmes parties (1052) situées au niveau de la zone d'affichage électroluminescent organique à matrice passive (20), dans lequel chacune de la pluralité de premières parties (1051) est plus éloignée du substrat (101) que ne l'est la couche d'anode (104), et chacune de la pluralité de deuxièmes parties (1052) est située à l'intérieur d'une rainure de séparation (103) de la pluralité de rainures de séparation (103) et n'est pas reliée à une première partie (1051) de la pluralité de premières parties (1051) adjacentes à chacune de la pluralité de deuxièmes parties (1052).

3. Substrat d'affichage électroluminescent organique (1) selon la revendication 1, dans lequel chacune de la pluralité de parties de blindage (1042) comporte deux bandes de blindage (1042a, 1042b) situées des deux côtés de la rainure (1020) et espacées l'une de l'autre, et une projection orthographique de chacune des deux bandes de blindage (1042a, 1042b) sur le substrat (101) chevauche partiellement la projection orthographique de la rainure (1020) sur le substrat (101).

4. Substrat d'affichage électroluminescent organique (1) selon la revendication 3, comportant en outre une première couche métallique de données (115), une première couche inorganique (116), une deuxième couche métallique de données (117), la couche de définition de pixels (107) et une couche d'espacement (108) du côté donné du substrat (101), dans lequel :
la couche organique (102) comporte une première couche organique (1021) et une deuxième couche organique (1022) ;
la première couche métallique de données (115), la première couche inorganique (116), la première couche organique (1021), la deuxième couche métallique de données (117), la deuxième couche organique (1022), la couche d'anode (104), la couche de définition de pixels (107), la couche d'espacement (108), la couche fonctionnelle organique (105) et la couche de cathode (106) sont agencées séquentiellement le long d'une direction s'éloignant du substrat (101) ; et
dans la zone d'affichage électroluminescent organique à matrice passive (20), la deuxième couche métallique de données (117) est connectée à la première couche métallique de données (115) par le biais d'une pluralité de premiers trous d'interconnexion (6a) et connectée à la couche d'anode (104) par le biais d'une pluralité de deuxièmes trous d'interconnexion (6b), et deux quelconques de la pluralité de premières anodes (1041) adjacentes l'une à l'autre le long de la première direction sont connectées entre elles par le biais de la première couche métallique de données (115) ou de la deuxième couche métallique de données (117).

5. Substrat d'affichage électroluminescent organique (1) selon la revendication 4, dans lequel chacune de la pluralité de rainures (1020) pénètre à travers la deuxième couche organique (1022) et s'étend dans la première couche organique (1021).

6. Substrat d'affichage électroluminescent organique (1) selon la revendication 4, dans lequel une projection orthographique de chacune de la pluralité de rainures (1020) sur le substrat (101) présente une largeur de 5 micromètres à 10 micromètres le long de la première direction.

7. Substrat d'affichage électroluminescent organique (1) selon la revendication 4, dans lequel chacune de la pluralité de rainures (1020) sur le substrat (101) présente une profondeur de 2 micromètres à 2,5 micromètres le long d'une direction perpendiculaire au substrat (101).

8. Substrat d'affichage électroluminescent organique (1) selon la revendication 4, dans lequel un angle entre chacune des deux parois latérales (1020a) et une paroi inférieure (1020b) de chacune de la pluralité de rainures (1020) va de 120 degrés à 140 degrés.

9. Substrat d'affichage électroluminescent organique (1) selon la revendication 4, dans lequel une partie de la projection orthographique de chacune des deux bandes de blindage (1042a, 1042b) sur le substrat (101) chevauchant la projection orthographique de la rainure (1020) sur le substrat (101) présente une largeur de 0,8 micromètre à 1 micromètre le long de la première direction.

10. Substrat d'affichage électroluminescent organique (1) selon la revendication 4, comportant en outre une zone d'affichage électroluminescent organique à matrice active (50), le substrat d'affichage électroluminescent organique (1) comportant en outre une couche semi-conductrice (109), une première couche isolante (110), une première couche métallique de grille (111), une deuxième couche isolante (112), une deuxième couche métallique de grille (113) et une troisième couche isolante (114) qui sont situées entre le substrat (101) et la première couche métallique de données (115) et agencées séquentiellement le long de la direction s'éloignant du substrat (101), dans lequel :
dans la zone d'affichage électroluminescent organique à matrice active (50), la première couche métallique de données (115) est connectée à la couche de semi-conducteurs (109) par le biais d'une pluralité de troisièmes trous d'interconnexion (6c) et connectée à la deuxième couche métallique de données (117) par le biais d'une pluralité de quatrièmes trous d'interconnexion (6d), et
la couche d'anode (104) est connectée à la deuxième couche métallique de données (117) par le biais d'une pluralité de cinquièmes trous d'interconnexion (6e)
éventuellement, dans lequel la zone d'affichage électroluminescent organique à matrice active (50) entoure une partie d'un bord de la zone d'affichage électroluminescent organique à matrice passive (20) ; ou la zone d'affichage électroluminescent organique à matrice active (50) entoure le bord de la zone d'affichage électroluminescent organique à matrice passive (20).

11. Substrat d'affichage électroluminescent organique (1) selon l'une quelconque des revendications 1-10, dans lequel le substrat (101) comporte une première couche flexible organique (101a), une deuxième couche flexible organique (101c) et une première couche barrière inorganique (101b) située entre la première couche flexible organique (101a) et la deuxième couche flexible organique (101c).

12. Dispositif d'affichage électroluminescent organique (100), **caractérisé en ce qu'**il comporte le substrat d'affichage électroluminescent organique (1) selon l'une quelconque des revendications 1-11 ;
éventuellement, dans lequel :
le substrat d'affichage électroluminescent organique (1) comporte en outre une zone d'affichage électroluminescent organique à matrice active (50) ; et
le dispositif d'affichage électroluminescent organique (100) comporte en outre au moins un dispositif fonctionnel (30), dont une projection orthographique sur le substrat d'affichage électroluminescent organique (1) est située au niveau de la zone d'affichage électroluminescent organique à matrice passive (20).

13. Procédé de fabrication d'un substrat d'affichage électroluminescent organique (1) comportant une zone d'affichage électroluminescent organique à matrice passive (20), le procédé de fabrication comportant :
la formation (S1) d'une couche organique (102) d'un côté d'un substrat (101) ;
la formation (S2) d'une couche d'anode (104) sur une surface de la couche organique (102) à l'écart du substrat (101), dans lequel la couche d'anode (104) comporte
une pluralité de premières anodes (1041) situées au niveau de la zone d'affichage électroluminescent organique à matrice passive (20) et agencées en un réseau, et
une pluralité de parties de blindage (1042) situées au niveau de la zone d'affichage électroluminescent organique à matrice passive (20), espacées le long de la première direction et s'étendant le long de la deuxième direction, dans lequel des projections orthographiques de la pluralité de parties de blindage (1042) sur le substrat (101) sont réparties dans des espaces de projections orthographiques de la pluralité de premières anodes (1041) sur le substrat (101), qui s'étendent le long de la deuxième direction ;
la formation (S3) d'une couche de définition de pixels (107) et d'une couche d'espacement (108) séquentiellement d'un côté de la couche d'anode (104) à l'écart du substrat (101) ;
la gravure (S4) de la couche organique (102) pour former une pluralité de rainures (1020) situées au niveau de la zone d'affichage électroluminescent organique à matrice passive (20), espacées le long de la première direction et s'étendant le long de la deuxième direction, dans lequel des projections orthographiques de la pluralité de rainures (1020) sur le substrat (101) sont réparties dans des espaces de projections orthographiques de la pluralité de premières anodes (1041) sur le substrat (101), qui s'étendent le long de la deuxième direction, et une projection orthographique de chacune de la pluralité de rainures (1020) sur le substrat (101) chevauche partiellement une projection orthographique d'une partie de blindage de la pluralité de parties de blindage (1042) sur le substrat (101) pour former une pluralité de rainures de séparation (103) ; et
la formation (S5) d'une couche fonctionnelle organique (105) et d'une couche de cathode (106) séquentiellement d'un côté de la couche d'espacement (108) à l'écart du substrat (101), dans lequel la couche de cathode (106) comporte une pluralité de bandes de cathode (1061) et une pluralité de parties de matériau de cathode (1062), la pluralité de bandes de cathode (1061) et la pluralité de parties de matériau de cathode (1062) sont situées au niveau de la zone d'affichage électroluminescent organique à matrice passive (20), s'étendent le long de la deuxième direction et sont agencées alternativement le long de la première direction, chacune de la pluralité de bandes de cathode (1061) est plus éloignée du substrat (101) que ne l'est la couche d'anode (104), et chacune de la pluralité de parties de matériau de cathode (1062) est située à l'intérieur d'une rainure de séparation (103) de la pluralité de rainures de séparation (103) et n'est pas reliée à une bande de cathode (1061) de la pluralité de bandes de cathode (1061) adjacentes à chacune de la pluralité de parties de matériau de cathode (1062),
**caractérisé en ce que**
un matériau d'une partie de blindage (1042) est le même qu'un matériau d'une première anode (1041) et espacé de la première anode (1041) par la couche de définition de pixels (107).

14. Procédé de fabrication selon la revendication 13, dans lequel la gravure de la couche organique (102) comporte :
la formation (S41) d'un masque dur du côté donné de la couche d'espacement (108) à l'écart du substrat (101), dans lequel des zones du masque dur correspondant à des encoches de la pluralité de rainures de séparation (103) sont des zones creuses ;
la gravure à sec (S42) de la couche organique (102) à travers le masque dur pour former la pluralité de rainures de séparation (103) ; et
le décollement (S43) du masque rigide ;
éventuellement, dans lequel la formation du masque rigide comporte :
la formation d'une couche de recouvrement de masque dur (3010) et d'une couche de recouvrement en résine photosensible (302) séquentiellement du côté donné de la couche d'espacement (108) à l'écart du substrat (101) ;
l'exposition et le développement de la couche de recouvrement en résine photosensible (302) séquentiellement pour obtenir un masque protecteur en résine photosensible, dans lequel des zones du masque protecteur en résine photosensible correspondant aux encoches de la pluralité de rainures de séparation (103) sont des zones creuses ; et
la gravure humide de la couche de recouvrement de masque dur (3010) à travers le masque protecteur en résine photosensible pour obtenir le masque dur ;
éventuellement, dans lequel un matériau du masque dur comporte de l'oxyde métallique ;
éventuellement, dans lequel un matériau du masque dur comporte de l'oxyde d'indium-gallium-zinc.

15. Procédé de fabrication selon l'une quelconque des revendications 13 à 14, dans lequel la formation de la couche organique (102) comporte la formation d'une première couche organique (1021) et d'une deuxième couche organique (1022) séquentiellement du côté donné du substrat (101), et le procédé de fabrication comporte en outre :
la formation d'une première couche métallique de données (115) et d'une première couche inorganique (116) séquentiellement du côté donné du substrat (101) avant la formation de la première couche organique (1021) ; et
la formation d'une deuxième couche métallique de données (117) d'un côté de la première couche organique (1021) à l'écart du substrat (101) après la formation de la première couche organique (1021) et avant la formation de la deuxième couche organique (1022),
dans lequel dans la zone d'affichage électroluminescent organique à matrice passive (20), la deuxième couche métallique de données (117) est connectée à la première couche métallique de données (115) par le biais d'une pluralité de premiers trous d'interconnexion (6a) et connectée à la couche d'anode (104) par le biais d'une pluralité de deuxièmes trous d'interconnexion (6b), et deux quelconques de la pluralité de premières anodes (1041) adjacentes l'une à l'autre le long de la première direction sont connectées entre elles par le biais de la première couche métallique de données (115) ou de la deuxième couche métallique de données (117) ;
éventuellement, dans lequel chacune de la pluralité de rainures (1020) pénètre à travers la deuxième couche organique (1022) et s'étend dans la première couche organique (1021) ;
éventuellement, dans lequel le substrat d'affichage organique électroluminescent (1) comporte en outre une zone d'affichage organique électroluminescent à matrice active (50), et le procédé de fabrication comporte en outre :
la formation d'une couche semi-conductrice (109), d'une première couche isolante (110), d'une première couche métallique de grille (111), d'une deuxième couche isolante (112), d'une deuxième couche métallique de grille (113), et d'une troisième couche isolante (114) séquentiellement du côté donné du substrat (101) avant de former la première couche métallique de données (115), dans lequel dans la zone d'affichage électroluminescent organique à matrice active (50), la première couche métallique de données (115) est connectée à la couche de semi-conducteur (109) par le biais d'une pluralité de troisièmes trous d'interconnexion (6c) et connectée à la deuxième couche métallique de données (117) par le biais d'une pluralité de quatrièmes trous d'interconnexion (6d), et la couche d'anode (104) est connectée à la deuxième couche métallique de données (117) par le biais d'une pluralité de cinquièmes trous d'interconnexion (6e).
